# EUROPEAN PATENT APPLICATION

(11) **EP 3 168 333 A1**
(43) Date of publication of application: **17.05.2017**
(21) Application number: 16150972.4
(22) Date of filing: 12.01.2016
(51) Int. Cl.: D01F 1/00, H01B 3/28, H01B 3/30, H01B 3/44, H01B 7/40, H05K 1/03, H05K 3/10, H05K 3/20, H05K 3/28

(54) **PLASTIC-CLADDING FILAMENT**

(30) Priority: 13.11.2015 TW 104218296 U
(71) Applicant: King's Metal Fiber Technologies Co., Ltd., 42060 Taichung City (TW)
(72) Inventor: KANG, Yu Hsun, 10451 Taipei City (TW); LIAO, Shu Fen, 10451 Taipei City (TW); HOU, Jaang Jiun, 10451 Taipei City (TW); WANG, Hao Chen, 10451 Taipei City (TW); CHEN, Reng Sho, 10451 Taipei City (TW)
(74) Representative: Cabinet Chaillot

(57) **Abstract**

A plastic-cladding filament structure includes a combined arrangement of a thermoplastic elastomer and at least one conductive filament. The thermoplastic elastomer includes a rigid chain segment and a flexible chain segment. The at least one conductive filament is enclosed and housed in the thermoplastic elastomer so that the conductive filament may be attachable, through heating, melting, and bonding of the thermoplastic elastomer, in which through the property that the thermoplastic elastomer is solid in room temperature and gets melted to become liquid when heated to a predetermined temperature and gets solidified and bonded after being cooled, the thermoplastic elastomer that encloses and houses the conductive filament is allowed to attached to a fabric article or a base layer through solidification and bonding resulting from cooling, thereby improving utilization thereof.

## Description

### BACKGROUND OF THE INVENTION

### 1. Field of the Invention

The present invention relates generally to a plastic-cladding filament structure, and more particularly to a combined arrangement of a thermoplastic elastomer and at least one conductive filament, in which the thermoplastic elastomer has a property of being solidified and bonded after cooling so as to allow the thermoplastic elastomer that encloses and houses the conductive filament to be solidified and bonded, due to being cooled down, to a fabric article or a base layer, making it applicable to all sorts of conductive filaments, such as stainless steel based conductive filaments, carbon fiber based conductive filaments, and sputtered fiber based conductive filaments.

### 2. Description of Related Art

Modern fabric articles must suit the needs for comfortableness, ventilation, and cooling when they are worn. Thus, manufacturers are devoted themselves to researches and development of new fibers and filaments and new ways of weaving and knitting, pursuing such performance of fabric articles just mentioned.

Recently, development is made on the so-called smart clothing by the manufacturers, which is a cloth equipped with electronic components and thus involving a smart function and, in addition, may be repeatedly washable and provides functionality of detecting physiological conditions, such as electrocardiograph, body temperature, breath, movement, and falling down and providing secured physiological signal monitoring and recording service through timely wireless transmission. The early way of including a flexible sheet embedded in clothing has been improved and evolved to inclusion of a conductive filament in a fiber in order to achieve control of electrical current and electrical voltage and transmission of detection signals.

However, the state-of-the-art techniques of including a conductive filament in a fiber for making, through weaving or knitting, a fabric article may cause shorting or poor contact by breaking the conductive filament through repeated washing or kneading so that the performance of control of electrical current and electrical voltage and transmission of detection signals becomes deteriorated. It is also very difficult to repair the conductive filament. Thus, the fabric article may be simply disposed of when situations, such as shorting or poor contact, occur and repeated use become impossible.

Thus, in view of the above problems, the present invention aims to provide a plastic-cladding filament structure that provides an effect of repeated attachability and facilitating subsequent processing of a product of clothing, allowing for easy operation by a user for assembly.

### SUMMARY OF THE INVENTION

The primary object of the present invention is to provide a plastic-cladding filament structure, which comprises a combined arrangement of a thermoplastic elastomer and at least one conductive filament. The thermoplastic elastomer comprises a rigid chain segment and a flexible chain segment. The at least one conductive filament is enclosed and housed in the thermoplastic elastomer, so that the conductive filament may be attachable, through heating, melting, and bonding of the thermoplastic elastomer, in which through the property that the thermoplastic elastomer is solid in room temperature and gets melted to become liquid when heated to a predetermined temperature and gets solidified and bonded after being cooled, the thermoplastic elastomer that encloses and houses the conductive filament is allowed to attached to a fabric article or a base layer through solidification and bonding resulting from cooling, thereby improving utilization thereof.

Another object of the present invention is to provide a plastic-cladding filament structure, wherein the thermoplastic elastomer comprises a primary ingredient comprising one of thermoplastic styrene elastomer (TPS), thermoplastic polyurethane (TPU), thermoplastic vulcanizate (TPV), thermoplastic polyolefin (TPO), thermoplastic elastomer either ester (TPEE), or thermoplastic elastomer-baged on ethylene vinyl acetate (TP-EVA), in combination with additives, such as tackifiers, plasticizers, anti-oxidants, fire retardant, and fillers, subjecting to melting and mixing to form a solid binder and melting temperature is between 65°C and 180°C and in use, melting of the thermoplastic elastomer can be achieved simply through heating and after cooling, solidification and bonding may be accomplished, thereby allowing bonding to all sorts of bases or a fabric article to improve overall attachability in use.

A secondary object of the present invention is to provides a plastic-cladding filament structure, wherein the thermoplastic elastomer is attached, through heating, melting, and bonding, to a fabric article and the fabric article comprises one of a garment, trousers, gloves, underwear, a vest, a corsage, and a tube-top, wherein when the thermoplastic elastomer is attached, through heating, melting, and bonding, to the fabric article, the conductive filament can be arranged in a linear configuration, or alternatively, the conductive filament can be bent to show an S-shaped configuration or a Z-shaped configuration so as to improve extendibility thereof, protecting the conductive filament from being easily pulled to break, with the thermoplastic elastomer that encloses and houses therein the conductive filament being directly attached, through the heating, melting, and bonding, to the base layer, so that the conductive filament may form a circuit that complies with the configuration of the base layer for achieving the performance of signal transmission or electrical power transmission thereby improving overall utilization.

Another secondary object of the present invention is to provide a plastic-cladding filament structure, wherein the thermoplastic elastomer is attached, through heating, melting, and bonding, to a base layer and the base layer is one of paper, fabric article, film, plate, or elastomer. The base layer is combined with a fabric article by means of one of sewing, ultrasonic means, thermal fusion, and adhesive. The fabric article is one of a garment, trousers, gloves, underwear, a vest, a corsage, and a tube-top, so that through different designs of the base layer, the thermoplastic elastomer that encloses and houses the conductive filament may allow the base layer to be attached to fabric articles made of different materials, allowing for easy formation of a circuit on the fabric article and the base layer may form a protection layer for protecting the conductive filament to prevent the conductive filament from breaking or shorting due to application of an external thereto, thereby improving overall protection.

A further object of the present invention is to provide a plastic-cladding filament structure, wherein the thermoplastic elastomer is attached, through heating, melting, and bonding, to a base layer that is a plastic band, wherein the plastic band comprises an adhesive surface and the thermoplastic elastomer that encloses and houses the conductive filament is attached, through heating, melting, and bonding, to the adhesive surface of the plastic band, so that attachability may be provided by means of the adhesive surface of the plastic band. Alternatively, the plastic band does not comprise an adhesive surface, and the thermoplastic elastomer that encloses and houses the conductive filament is first attached, through heating, melting, and bonding, to the plastic band that does not comprises an adhesive surface and a layer of adhesive is coated on that surface of that plastic band that is not adhesive and to which the thermoplastic elastomer that encloses and houses the conductive filament is attached to provide the thermoplastic elastomer that encloses and houses the conductive filament with attachability by means of the adhesive coated on the plastic band, so that the present invention allows for use of a plastic band to adhesively attach the thermoplastic elastomer that encloses and houses the conductive filament to all sorts of fabric article, providing an effect of repeated attachability and adjustability for facilitating subsequent processing of product thereby improving overall convenience.

To achieve the above objects, the present invention provides a plastic-cladding filament structure, which comprises a thermoplastic elastomer and at least one conductive filament. The thermoplastic elastomer comprises a rigid chain segment and a flexible chain segment. The at least one conductive filament is enclosed and housed in the thermoplastic elastomer to provide the conductive filament with attachability through heating, melting, and bonding of the thermoplastic elastomer.

### BRIEF DESCRIPTION OF THE DRAWINGS

The present invention can be fully understood from the following detailed description and preferred embodiments with reference to the accompanying drawings, in which:
FIG. 1 is a perspective view showing a primary embodiment of the present invention;
FIG. 2 is a schematic view illustrating a thermoplastic elastomer that encloses and houses a conductive filament attached, through heating, melting, and bonding, to a fabric article in a first example of application of the present invention;
FIG. 3 is a schematic view illustrating a thermoplastic elastomer that encloses and houses a conductive filament attached, through heating, melting, and bonding, to a base layer in a second example of application of the present invention;
FIG. 4 is a cross-sectional view taken along line A-A, illustrating the thermoplastic elastomer that encloses and houses the conductive filament attached, through heating, melting, and bonding, to the base layer in the second example of application of the present invention;
FIG. 5 is a schematic view illustrating the base layer that carries the thermoplastic elastomer that encloses and houses the conductive filament adhesively attached to a fabric articles according to the second example of application of the present invention;
FIG. 6 is a schematic view illustrating a thermoplastic elastomer that encloses and houses a plurality of conductive filaments attached, through heating, melting, and bonding, to a base layer according to the second example of application of the present invention;
FIG. 7 is a schematic view illustrating a thermoplastic elastomer that encloses and houses a conductive filament attached, through heating, melting, and bonding, to a plastic band that comprises an adhesive surface in a third example of application of the present invention; and
FIG. 8 is a schematic view illustrating a thermoplastic elastomer that encloses and houses a conductive filament attached, through heating, melting, and bonding, to a plastic band that does not comprise an adhesive surface in a fourth example of application of the present invention.

### DETAILED DESCRIPTION OF THE PREFERRED EMBODIMENTS

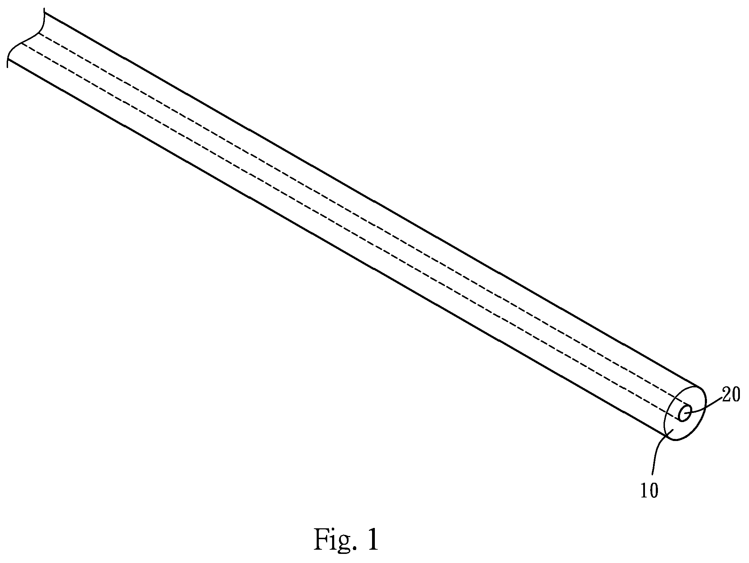

Referring to FIGS. 1-8, schematic views are given to illustrate embodiments of the present invention. A preferred embodiment of the present invention provides a plastic-cladding filament structure, which is applicable to bing adhesively attached to a fabric article 30 to provide the fabric article 30 with a circuit that achieves performance of signal transmission or electrical power transmission.

In a primary example of embodiment of the present invention, the plastic-cladding filament structure generally comprises a thermoplastic elastomer (TPE) 10 and at least one conductive filament 20 (as shown in FIG. 1). The thermoplastic elastomer 10 includes a rigid chain segment (also referred to as a hard segment) and a flexible chain segment (also referred to as a soft segment), the former influencing elasticity, low temperature property and hardness, tearing strength, and modulus of a product, while the later providing slight chemical cross-linking and physical cross-linking resulting from hydrogen bonds between molecular chains and easy formation of crystalline zones. They will be damaged when heated or dissolved to allow polymers to induce plasticization flowing and will regain the original shape after cooling.

Thermoplastic elastomer 10 is also referred to as thermoplastic rubber (TPR), which is a material showing properties of both rubber and thermoplastics. The thermoplastic elastomer 10 used herein can be a material including a primary ingredient comprising one of thermoplastic styrene elastomer (TPS), thermoplastic polyurethane (TPU), thermoplastic vulcanizate (TPV), thermoplastic polyolefin (TPO), thermoplastic elastomer either ester (TPEE), or thermoplastic elastomer-baged on ethylene vinyl acetate (TP-EVA), in combination with additives, such as tackifiers, plasticizers, anti-oxidants, fire retardant, and fillers, subjecting to melting and mixing to form a solid binder.

Thermoplastic styrene elastomer (TPS) used herein can be one of styrene butadiene styrene (SBS), styrene isoprene styrene (SIS), styrene ethylene butylene styrene (SEBS), and styrene ethylene propylene styrene (SEPS). Thermoplastic polyurethane (TPU) used herein comprises a rigid chain segment that is formed of polyurethane (PUR) and a flexible chain segment that is formed of polyether or polyester. Thermoplastic polyolefin (TPO) used herein comprises a rigid chain segment that is formed of polyethylene, polypropylene, or polybutene and a flexible chain segment formed of rubber. The thermoplastic elastomer 10 has a melting temperature between 65°C and 180°C and in use, melting of the thermoplastic elastomer 10 can be achieved simply through heating and after cooling, solidification and bonding may be accomplished.

Further, the at least one conductive filament 20 is formed of a material comprising one of stainless steel, carbon fiber, sputtered fiber, or other materials showing similar electrical conduction property in order to provide the conductive filament 20 with a property of electrical conductivity. The at least one conductive filament 20 is enclosed and housed in the thermoplastic elastomer 10 so that the conductive filament 20 may use the thermoplastic elastomer 10 for melting and bonding, in which through the property of the thermoplastic elastomer 10 that is solid in room temperature but becomes a liquid when heated to a predetermined temperature and melted and becomes solidified and bonded after being cooled, the thermoplastic elastomer 10 that encloses the conductive filament 20 may get solidified and bonded after being cooled down.

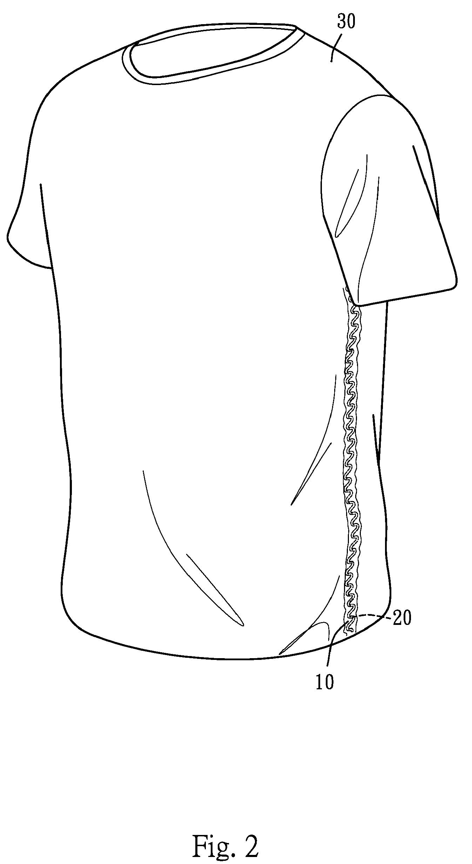

A first example of application of the plastic-cladding filament structure according to the present invention comprises a thermoplastic elastomer 10 and at least one conductive filament 20 and the at least one conductive filament 20 is enclosed and hosed in the thermoplastic elastomer 10 so that the thermoplastic elastomer 10 allows for direct heating, melting, and bonding to any portion or stitching site of a piece of fabric article 30 (as shown in FIG. 2). The fabric article 30 can be one of a garment, trousers, gloves, underwear, a vest, a corsage, and a tube-top or other types of fabric articles 30 made by means of weaving/knitting and sewing. The fabric article 30 may comprise an elastic material or a non-elastic material.

Further, when the thermoplastic elastomer 10 is attached, through heating, melting, and bonding, to the fabric article 30, the conductive filament 20 can be arranged in a linear configuration, or alternatively, the conductive filament 20 can be bent to show an S-shaped or Z-shaped configuration with the conductive filament 20 enclosed in the thermoplastic elastomer 10 directly attached, through the heating, melting, and bonding, to the fabric article 30 so that the conductive filament 20 may form a circuit that complies with the configuration of the fabric article 30 for achieving the performance of signal transmission or electrical power transmission.

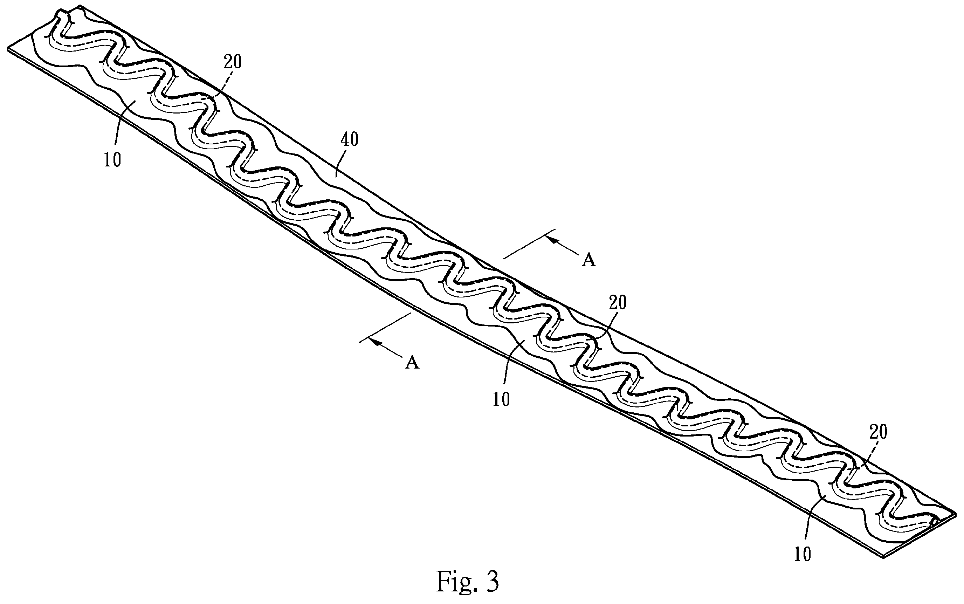

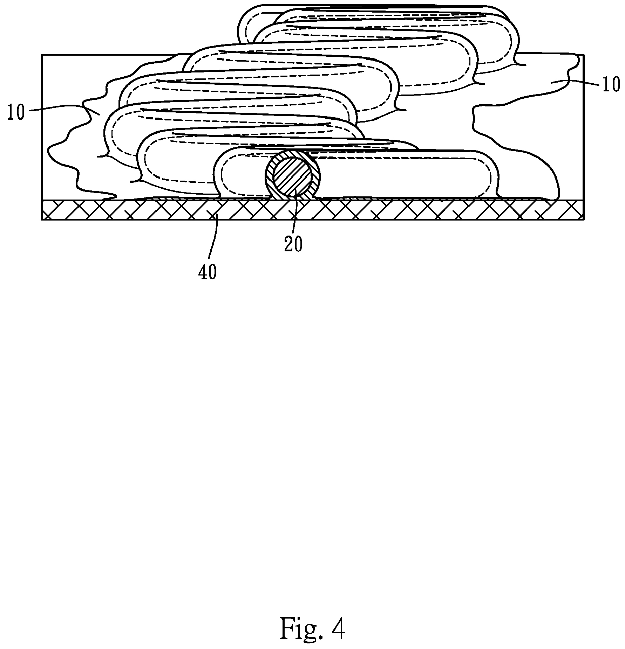

A second example of application of the plastic-cladding filament structure of the present invention comprises a thermoplastic elastomer 10 and at least one conductive filament 20 and the at least one conductive filament 20 is enclosed and hosed in the thermoplastic elastomer 10. The thermoplastic elastomer 10 is attached, through heating, melting, and bonding, to a base layer 40 (as shown in FIGS. 3 and 4). The base layer 40 can be one of paper, fabric, film, plate, and elastic body. Paper used herein can be all sorts of paper product (not shown) made of pulp, such as an ordinary paper sheet, a cardboard, and a corrugated paperboard. Fabric used herein can be a piece of fabric (not shown) formed by weaving or knitting or otherwise processing all sorts of fibers or filaments. Film used herein can be a flexible film of plastics or a flexible film of carbon material or other films formed of flexible materials (not shown). Plate used herein can be a rigid plate made of plastics, a rigid plate made of metals, a rigid plate made of carbon materials, or plates made of other rigid materials (not shown). The elastic body used herein can be a fabric or an elastic band (not shown) formed by weaving or knitting or otherwise processing all sorts of elastic fibers or filaments.

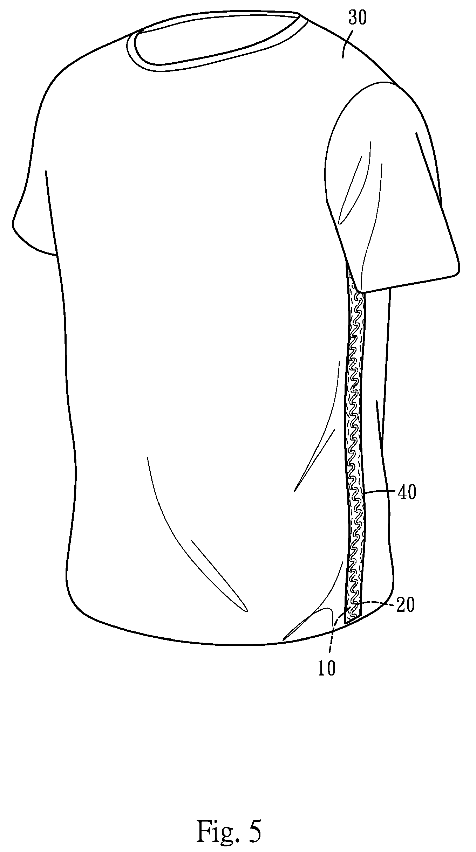

Further, the base layer 40 can be combined with a fabric article 30 (as shown in FIG. 5), and the combination can be achieved by means of one of sewing, ultrasonic means, thermal fusion, and adhesive (sewing being taken as an example in the instant embodiment). The base layer 40 can be combined any portion or a sewing site of the fabric article 30. The fabric article 30 can be one of a garment, trousers, gloves, underwear, a vest, a corsage, and a tube-top or other types of fabric articles 30 made by means of weaving/knitting and sewing. The fabric article 30 may comprise an elastic material or a non-elastic material. Through different designs of the base layer 40, the thermoplastic elastomer 10 that encloses and houses the conductive filament 20 may allow the base layer 40 to be attached to fabric articles 30 made of different materials, allowing for easy formation of a circuit on the fabric article 30. Further, the base layer 40 may form a protection layer for protecting the conductive filament 20 to prevent the conductive filament 20 from breaking or shorting due to application of an external thereto.

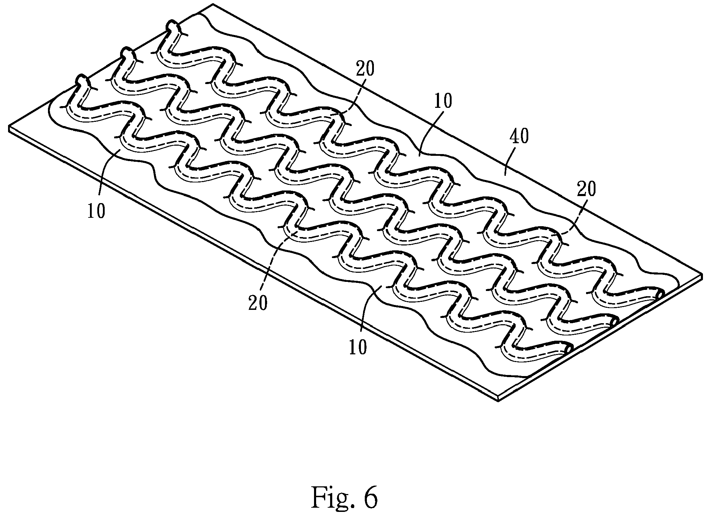

Further, when the thermoplastic elastomer 10 is attached, through heating, melting, and bonding, to the fabric article 30, the conductive filament 20 can be arranged in a linear configuration, or alternatively, the conductive filament 20 can be bent to show an S-shaped configuration (as shown in FIGS. 3 and 6) or a Z-shaped configuration so as to improve extendibility thereof, protecting the conductive filament 20 from being easily pulled to break, with the thermoplastic elastomer 10 that encloses and houses therein the conductive filament 20 being directly attached, through the heating, melting, and bonding, to the base layer 40, so that the conductive filament 20 may form a circuit that complies with the configuration of the base layer 40 for achieving the performance of signal transmission or electrical power transmission.

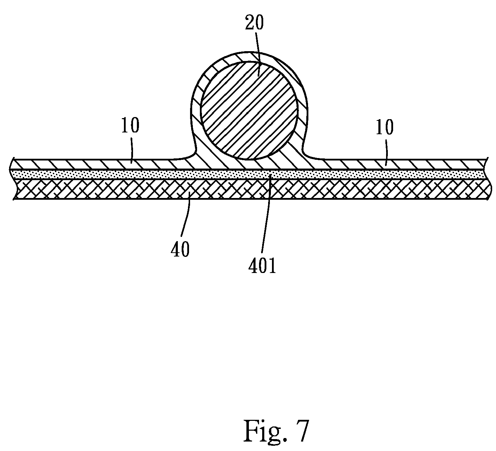

A third example of application of the plastic-cladding filament structure of the present invention comprises a thermoplastic elastomer 10 and at least one conductive filament 20 and the at least one conductive filament 20 is enclosed and hosed in the thermoplastic elastomer 10. The thermoplastic elastomer 10 is attached, through heating, melting, and bonding, to a base layer 40. The base layer 40 can be a plastic band, wherein the plastic band comprises an adhesive surface 401 (as shown in FIGS. 7 and 5). The thermoplastic elastomer 10 that encloses and houses the conductive filament 20 is attached, through heating, melting, and bonding, to the adhesive surface 401 of the plastic band by allowing the thermoplastic elastomer 10 that encloses and houses the conductive filament 20 to bond, through solidification, to the plastic band. The adhesive surface 401 of the plastic band then allows for attachment to the fabric article 30. The thermoplastic elastomer 10 that encloses and houses the conductive filament 20, when attached to the fabric article 30, can be mounted to a sewing site or a cutting site of the fabric article 30 to shield the sewing site or the cutting site and also to improve aesthetics of the fabric article 30.

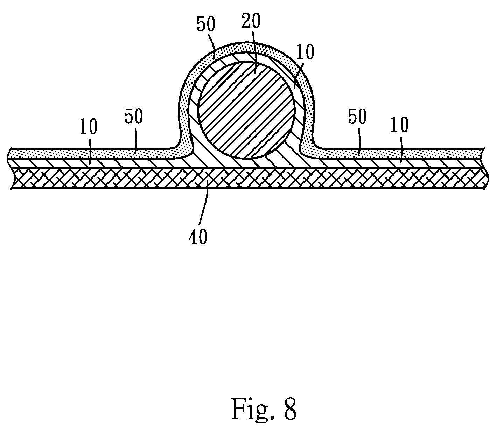

A fourth example of application of the plastic-cladding filament structure of the present invention comprises a thermoplastic elastomer 10 and at least one conductive filament 20 and the at least one conductive filament 20 is enclosed and hosed in the thermoplastic elastomer 10. The thermoplastic elastomer 10 attached, through heating, melting, and bonding, to a base layer 40. The base layer 40 can be a plastic band, wherein the plastic band does not include an adhesive surface (as shown in FIGS. 8 and 5). The thermoplastic elastomer 10 that encloses and houses the conductive filament 20 is first attached, through heating, melting, and bonding, to a surface of the plastic band that is not adhering by allowing the thermoplastic elastomer 10 that encloses and houses the conductive filament 20 to bond, through solidification, to the plastic band. Then, a layer of adhesive 50 is applied to the non-adhering surface of the plastic bond on which the thermoplastic elastomer 10 that encloses and houses the conductive filament 20 is attached to allow the plastic band that carries the thermoplastic elastomer 10 that encloses and houses the conductive filament 20 to be attached, through the coated layer of adhesive 50, to the fabric article 30, so that the present invention allows for use of a plastic band to adhesively attach the thermoplastic elastomer 10 that encloses and houses the conductive filament 20 to all sorts of fabric article 30, providing an effect of repeated attachability and adjustability for facilitating subsequent processing of product thereby improving overall convenience.

Further, in the above-described first, second, third, and fourth examples of application of the plastic-cladding filament structure according to the present invention, the fabric article is provided with signal transmission contact terminals (not shown) and the signal transmission contact terminal is connected to at least one detection module (not shown), wherein signal transmission or electrical power transmission between the signal transmission contact terminals and the at least one detection module is achieved with the thermoplastic elastomer that encloses and houses the conductive filament. The detection module used herein may be formed by weaving or knitting a plurality of non-conductive yarns and a plurality of conductive yarns, or alternatively, an electrode plate that is entirely formed by weaving or knitting a plurality of conductive yarns so that the entire electrode plate shows a property of electrical conduction, allowing the detection module to detect a physiological signal or tilting of a human body that is then transmitted to the signal transmission contact terminals. Further, the signal transmission contact terminals may be combined with a signal transmitter (not shown), which comprises therein a wireless transmission module that transmits, in a wireless manner, the physiological signal or a wireless signal indicating variation of tilting of human body to an electronic device (such as a smart phone, an intelligent tablet computer, a notebook computer, a desktop computer, and medical facility) or cloud for facilitating understanding of the detection result to provide preventive medical treatment.

Based on the above detailed description, those skilled in the art may appreciate that the present invention can achieve the above-discussed objectives. However, it is noted that the above description is made only to a preferred embodiment of the present invention and is not intending to limit the true scope where the present invention may be put into practice. Thus, simple and equivalent variations and modifications made on the disclosure of the specification and the attached claims are all considered within the scope of the present invention.

## Claims

1. A plastic-cladding filament structure, comprising:
a thermoplastic elastomer, which comprises a rigid chain segment and a flexible chain segment; and
at least one conductive filament, which is enclosed and housed in the thermoplastic elastomer to provide the conductive filament with attachability through heating, melting, and bonding of the thermoplastic elastomer.

2. The plastic-cladding filament structure as claimed in Claim 1, wherein the thermoplastic elastomer comprises one of thermoplastic styrene elastomer (TPS), thermoplastic polyurethane (TPU), thermoplastic vulcanizate (TPV), thermoplastic polyolefin (TPO), thermoplastic elastomer either ester (TPEE), or thermoplastic elastomer-baged on ethylene vinyl acetate (TP-EVA) and the thermoplastic elastomer further comprises additives, selectively including a tackifier, a plasticizer, an anti-oxidant, a fire retardant, and a filler.

3. The plastic-cladding filament structure as claimed in Claim 2, wherein the thermoplastic styrene elastomer comprises one of styrene butadiene styrene (SBS), styrene isoprene styrene (SIS), styrene ethylene butylene styrene (SEBS), and styrene ethylene propylene styrene (SEPS).

4. The plastic-cladding filament structure as claimed in Claim 2, wherein thermoplastic polyurethane comprises a rigid chain segment that is formed of polyurethane (PUR) and a flexible chain segment that is formed of polyether or polyester and thermoplastic polyolefin comprises a rigid chain segment that is formed of polyethylene, polypropylene, or polybutene and a flexible chain segment formed of rubber.

5. The plastic-cladding filament structure as claimed in Claim 1, wherein the thermoplastic elastomer is attached, through heating, melting, and bonding, to a fabric article, which is one of a garment, trousers, gloves, underwear, a vest, a corsage, and a tube-top, the fabric article comprising an elastic material or a non-elastic material.

6. The plastic-cladding filament structure as claimed in Claim 5, wherein the thermoplastic elastomer that is attached, through heating, melting, and bonding, to the fabric article is such that the conductive filament is set in a linear form.

7. The plastic-cladding filament structure as claimed in Claim 5, wherein the thermoplastic elastomer that is attached, through heating, melting, and bonding, to the fabric article is such that the conductive filament is bent to show an S-shaped configuration or a Z-shaped configuration.

8. The plastic-cladding filament structure as claimed in Claim 1, wherein the thermoplastic elastomer is attached, through heating, melting, and bonding, to a base layer.

9. The plastic-cladding filament structure as claimed in Claim 8, wherein the base layer comprise one of paper, fabric article, film, plate, and elastomer.

10. The plastic-cladding filament structure as claimed in Claim 9, wherein the base layer is combined with a fabric article, which comprises one of a garment, trousers, gloves, underwear, a vest, a corsage, and a tube-top, the fabric article comprising an elastic material or a non-elastic material, the combination comprising one of sewing, ultrasonic means, thermal fusion, and adhesive.

11. The plastic-cladding filament structure as claimed in Claim 8, wherein the base layer comprises a plastic band, which comprises an adhesive surface, the thermoplastic elastomer that encloses and houses the conductive filament being attached, through heating, melting, and bonding, to the plastic band that comprises the adhesive surface to be provided with additional attachability by means of the adhesive surface of the plastic band.

12. The plastic-cladding filament structure as claimed in Claim 8, wherein the base layer comprises a plastic band, which comprises a non-adhesive surface, the thermoplastic elastomer that encloses and houses the conductive filament being attached, through heating, melting, and bonding, to the plastic band that comprises the non-adhesive surface, a layer of adhesive being coated on the non-adhesive surface of the plastic band to which the thermoplastic elastomer that encloses and houses the conductive filament is attached so as to provide the thermoplastic elastomer that encloses and houses the conductive filament with additional attachability by means of the adhesive coated on the plastic band.

13. The plastic-cladding filament structure as claimed in Claim 8, wherein the thermoplastic elastomer that is attached, through heating, melting, and bonding, to the base layer is such that the conductive filament is set in a linear form.

14. The plastic-cladding filament structure as claimed in Claim 8, wherein the thermoplastic elastomer that is attached, through heating, melting, and bonding, to the base layer is such that the conductive filament is bent to show an S-shaped configuration or a Z-shaped configuration.
